**Europäisches Patentamt**

**European Patent Office**

**Office européen des brevets**

(19)

(11) Veröffentlichungsnummer: **0 252 085 B1**

(12) # EUROPÄISCHE PATENTSCHRIFT

(45) Veröffentlichungstag der Patentschrift: **09.12.92**

(51) Int. Cl.⁵: **G01R 15/12**, G01R 15/08

(21) Anmeldenummer: **86902313.5**

(22) Anmeldetag: **27.03.86**

(86) Internationale Anmeldenummer:
**PCT/DE86/00143**

(87) Internationale Veröffentlichungsnummer:
**WO 86/05886 (09.10.86 86/22)**

(54) **SIGNALVERARBEITUNGSGERÄT MIT PEGELANPASSUNGSSCHALTUNG.**

(30) Priorität: **27.03.85 DE 3511593**
**27.03.85 DE 3511590**

(43) Veröffentlichungstag der Anmeldung:
**13.01.88 Patentblatt 88/02**

(45) Bekanntmachung des Hinweises auf die
Patenterteilung:
**09.12.92 Patentblatt 92/50**

(84) Benannte Vertragsstaaten:
**AT BE CH DE FR GB IT LI NL SE**

(56) Entgegenhaltungen:
**US-A- 4 034 291**

**Elektor, Band 2, No. 7,8, Juli/August 1976,
"Linear Scale Ohmmeter", Seite 758**

(73) Patentinhaber: **Siemens Aktiengesellschaft**

**W-1000 Berlin 13(DE)**

(72) Erfinder: **KOSLAR, Manfred**
**Benediktiner Str. 22**
**W-1000 Berlin 28(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 252 085 B1

EP 0 252 085 B1

## Beschreibung

Die Erfindung betrifft ein Signalverarbeitungsgerät der im Oberbegriff des Anspruchs 1 angegebenen Art.

Pegelanpassungsschaltungen finden bei Geräten zur Signalverarbeitung Anwendung, um bei unterschiedlichen Signalamplituden eine Anpassung an den Dynamikbereich der Signalverarbeitung im Gerät zu schaffen.

Ein derartiges Gerät ist beispielsweise aus der US-A 4.034.291 oder der Zeitschrift ELEKTOR (englisch), Vol.2, No.7-8, p.758, Jul-Aug 1976, bekannt.

Bei den bekannten Schaltungen wird eine Umschaltung der Verstärkungsfaktoren von Operationsverstärkerschaltungen in üblicher Weise dadurch bewirkt, daß die die Verstärkung bestimmenden Widerstände nach Art von Spannungsteilern umgeschaltet werden. Damit verändern sich aber auch die für Streusignale und sonstige störende Einflüsse jeweils maßgeblichen Signalpegel, so daß die Schaltung für eine hochwertige Signalverarbeitung für jedes eingestellte Spannungsteilerverhältnis erneut kompensiert werden müßte.

Der Erfindung liegt die Aufgabe zugrunde, ein Signalverarbeitungsgerät der vorstehenden Gattung anzugeben, bei dem eine Änderung des Verstärkungsfaktors ohne eine Beeinträchtigung durch Streupotentiale oder hohe zu schaltende Spannungen durchführbar ist.

Die Erfindung beruht auf der Erkenntnis, daß bei einem nach Art eines Operationsverstärkers zu betreibenden Eingangsverstärker die Umschaltung der Eingangsspannungsbereiche durch Veränderungen lediglich im Bereich der virtuellen Masse erfolgen kann, so daß die Schaltpunkte weder durch Streupotentiale noch durch hohe zu schaltende Spannungen beeinträchtigt sind.

Aus den Forderungen nach einem hohen Dynamikbereich, der gleichzeitigen Breitbandigkeit und nach einem hochohmigen und sicheren Eingangswiderstand resultiert der Aufbau einer Eichleitung mit hochohmigen Widerständen, da dieser mit Kompensationskapazitäten ausgestattet werden muß. Zur Verminderung des Bauteile- und Abgleichaufwands werden zwei durch einen Vorverstärker getrennte Teilerstufen verwendet - und zwar ein dekadischer Teiler und ein Stufenteiler, wobei der letztgenannte relativ niederohmig beschaltet sein kann.

Um die Verstärkungsfaktoren möglichst klein zu halten, wird eine Eingangsgrundteilung vermieden. Hierzu wurde vorteilhafterweise nicht, wie sonst üblich, der Eingang dem nicht invertierenden Eingang eines Trennverstärkers zugeführt, sondern ein potentiometrisch beschalteter diskret aufgebauter Operationsverstärker verwendet. Das hat den Vorteil, mit einem wirkwiderstand am Eingang arbeiten zu können, ohne eine Potentialabschwächung hinnehmen zu müssen.

Der damit erreichte Summationspunkt am Eingang des Verstärkers ist aus anderen Gründen sehr günstig. Er ist bei richtiger Auslegung potentialfrei und stellt gleichzeitig eine virtuelle Masse dar; vorzugsweise kann an diesem Punkt eine zusätzliche Regelspannung zugeführt werden, die zu einer DC-Verschiebung genutzt oder zu einer automatischen Nullpunktkalibration genutzt werden kann. Das wiederum verringert die Anforderungen an die Gleichspannungsstabilität des Verstärkers und führt bei entsprechender Beschaltung zur Möglichkeit einer vollautomatischen Nullpunktregelung und Kalibration. Dieses wiederum gestattet die Erfüllung der Forderungen nach Nullpunktstabilität, nach Meßgenauigkeit und Langzeitstabilität sowie im Verein mit dem Rechner die vollautomatische Messung des Wechselspannungs- und Gleichspannungsanteils eines Signals. Einer der entscheidenden Vorteile dieses Systems jedoch liegt im sehr vorteilhaften Eichteiler.

Die virtuelle Masse des Eingangs des potentiometrisch beschalteten Operationsverstärkers erlaubt es, die Forderung nach hohem und konstantem Eingangswiderstand für alle Schalterstufen zu erfüllen und einen Eingangsstromteiler zu erhalten. Da der Verstärker "stromgesteuert" ist, ergibt sich die erfindungsgemäße Möglichkeit, den Eingangsstrom zu teilen.

Sämtliche Teilerwiderstände lassen sich nach den Regeln der Parallelschaltung von Widerständen errechnen, wobei die eingangsseitigen Widerstände zwischen dem virtuellen Massepunkt des potentiometrisch beschalteten Verstärkers und dem Bezugspotential des Eingangs umgeschaltet werden. Durch die Parallelschaltung verkleinert sich die Spannungsverstärkung des Verstärkers entsprechend. Ein fester Widerstand verbleibt im Eingang, so daß sich eingangsseitig verschiedene "T"-Widerstandskonfigurationen bis zu einem zusammengefaßten Längswiderstand im Eingang ergeben, wobei der Querzweig bei der Berechnung des in den Verstärker fließenden Stroms außer Betracht bleiben kann.

Diese Lösung beruht auf der Erkenntnis, daß sich das Bezugspotential für das Ein- und Ausgangssignal des Operationsvertärkers und die virtuelle Masse gedanklich zusammenfassen lassen. Damit sind für das Eingangssignal - bezogen auf den Verbindungspunkt, der unabhängig vom Schaltzustand erhalten bleibt - und das Bezugs- bzw. virtuelle Massepotential die Verhältnisse (und somit der Eingangswiderstand zum Verstärker hin) konstant.

2

Der Verstärkungsfaktor der Operationsverstärkerschaltung wird dagegen ausschließlich durch den mit der virtuellen Masse verbundenen Teilwiderstand bestimmt und ist dementsprechend schaltbar.

Der zusätzliche Wirkwiderstand im Eingang dient der elektrischen Sicherheit und bewirkt eine Herabsetzung des Stroms bezüglich des Verbindungspunkts.

Im Vergleich zu den sonst üblichen Teilerschaltungen treten auch hier minimale Werte für die Kapazitäten auf. Die weiteren Vorteile dieser sehr günstigen Konfiguration seien ebenfalls aufgeführt:

Es ist ein Minimum von Präzisionswiderständen erforderlich.

Alle durch die Geometrie bedingten Streukapazitäten der Bauteile und der Leiterbahnen zu den Schaltern bleiben konstant, da sämtliche Bauteile bei allen Schalterstellungen immer an Masse in der gleichen Art verbunden werden, einmal an die virtuelle im anderen Fall an die reelle Masse.

Der Vorwiderstand ist relativ hochohmig (ungefähr 1 MOhm). Das bedeutet extreme Bedienungssicherheit, sofern auch die zugehörige Kapazität spannungsfest ausgebildet ist.

Die Eingangskapazität ist mit ca. 20 pF relativ klein.

In der Stufe höchster Empfindlichkeit kann der Verstärker im Gegensatz zu einem nicht invertierend beschalteten Verstärker trotz des hohen ohmschen Widerstandes ohne Grundteilung von 6 dB arbeiten, im Gegensatz dazu bietet er noch eine Verstärkungsmöglichkeit - bevorzugt ca. fünffach - an.

Einfacher Aufbau des Schalters (jeweils nur ein Kontaktwechsel pro Teilerstufe) und damit die günstige Realisierbarkeit mittels integrierter Analogschalter in CMOS-Technik.

Die Belastung des Signaleingangs ist konstant.

Der Strom im Rückführungszweig ist konstant.

Da der aktuelle für die Pegelanpassung wirksame Widerstand im Rückkopplungsnetzwerk des Operationsverstärkers aus einem oder mehreren Widerständen zusammengesetzt wird und die Anzahl der Widerstände insgesamt ein Minimum ist, ist auch die Belastung des Meßobjekts durch die Parallelschaltung ein Minimum. Bei vorgeschaltete Sicherheitswiderstand kann daher auch für einen minimalen Strom ausgelegt sein und bietet somit ein Maximum an Sicherheit.

Um bei bekannten Signalverarbeitungsgeräten eine Nullpunktverschiebung des Meßsignals, d.h. eine Verschiebung des Gleichspannungsanteils, zu erreichen, sind aufwendige Maßnahmen erforderlich, die insbesondere eine Einspeisung von veränderlichen Spannungspegeln zu internen Schaltungspunkten der Meßverstärker erfordern. Dabei ist die Auswirkung der jeweiligen Verschiebung von vornherein nur schwer zu beurteilen, so daß entsprechend dem vorgesehenen Anwendungsfall eine Eskalierung der einzuspeisenden Spannungen vorgenommen werden muß, die an den entsprechenden Anwendungsfall anzupassen ist. Insbesondere ist auch nachteilig, daß bei einer automatischen Nullpunktkompensation die Driftspannungen innerhalb einzelner Verstärkerstufen ebenfalls in das Ergebnis eingehen und insoweit eine vollständige Kompensation des Gleichspannungsbezugspunktes verschiedentlich nur mit aufwendigen Maßnahmen erreichbar ist.

Der in Anspruch 8 angegebenen Lösung liegt als vorteilhafte Weiterbildung der Erfindung die Aufgabe zugrunde, eine Eingangsschaltung der vorstehend genannten Art anzugeben, bei der eine Nullpunktkompensation bzw. Calibration des Gerätes auf einfache Weise möglich ist.

Diese Lösung beruht auf der Erkenntnis, daß bei Verwendung eines nach Art eines Operationsverstärkers potentiometrisch geschalteten Signalverstärkers die Einspeisung eines zusätzlichen eine gleichspannungsmäßige Verschiebung hervorrufenden Signals ohne Beeinflussung weiterer Signalstufen möglich ist. Da an diesem Punkt kein Potential gegen den Bezugspegel für die Eingangsspannung führt, entfällt auch eine störende Rückwirkung des Signals auf die Quelle der Kompensationsspannung. Durch Abgleich mit einem Bezugssignal kann ein Gleichspannungsabgleich bei Pausen in der Signalaufnahme zwischen periodisch erscheinenden Eingangssignalen regelmäßig vorgenommen werden, so daß die Anforderungen an die Driftfreiheit der Gleichspannungsverstärker entsprechend herabgesetzt sind.

Bei einem Meßgerät mit digitaler Signalverarbeitung wird die Gleichspannungskompensation bevorzugt in der Weise durchgeführt, daß, gesteuert von dem digitalen Signalverarbeitungsteil über einen Digital-Analog-Wandler, ein analoges Signal konstanter Amplitude generiert wird, welches dem Eingang des potentiometrisch beschalteten Operationsverstärkers am Punkt der virtuellen Masse zugeführt wird, wobei über einen weiteren Analog-Digital-Wandler ein Kompensationssignal eingespeist wird, welches solange verändert wird, bis in dem analogen Eingangsteil des Meßgerätes des nachgeschalteten digitalen Auswertungsteils das Ausgangssignal "null" erscheint. Für die weitere Verarbeitung bestehen zwei Möglichkeiten, wobei entweder das Kompensationssignal analog während der nachfolgenden Meßvorgänge weiter eingespeist wird oder aber bei diesen Messungen unter Abschaltung des analogen Kompensationssignals die digitalen Ergebnisse um den digitalen Zahlenwert korrigiert werden, der dem analog einzuspeisenden Kompensationssignal entspricht.

Bei einer bevorzugten Weiterbildung der Erfindung wird der eben beschriebene Signalweg zur Kalibrierung, d.h. insbesondere Linearisierung des analogen Eingangsteils herangezogen. Dabei wird in den zur Kalibrierung zur Verfügung stehenden Zeitintervallen zwischen aufeinanderfolgenden Meßvorgängen ein Analogsignal eingespeist, welches über den DigitalAnalog-Wandler mittels eines digitalen Signals erzeugt wird, welches in vorzugsweise äquidistanten Stufen verändert wird. Das am Ausgang des dem Meßverstärker nachgeschalteten Analog-Digital-Wandlers erscheinende digitale Ausgangssignal wird in seinen verschiedenen Stufen mit dem ursprünglichen stufenweise veränderten digitalen Eingangssignal verglichen und Ein- und Ausgangssignale gemeinsam in einem Speicher nach Art einer Tabelle abgelegt. Auf diese Weise können alle digitalen Signalwerte mittels der Tabelle korrigiert werden, so daß eine lineare Signalübertragung über den gesamten Eingangsbereich sichergestellt ist.

Bei einer anderen bevorzugten Weiterbildung der Erfindung ist eine Anwendung auch bezüglich des Wechselspannungsverhaltens des Eingangsteils möglich. Die Kalibrierung erfolgt in günstiger Weise getrennt für unterschiedliche Meßbereiche, wobei ein Abfragesignal,das die Position der Eingangsteiler kennzeichnet, zur Adressierung von in unterschiedlichen Speicherbereichen festgehaltenen, den verschiedenen Meßbereichen zugeordneten Digitalwerten dient.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:

Figuren 1a bis c eine Prinzipschaltung des Eingangsteilers mit Verstärker in verschiedenen Schaltzuständen,

Figur 2 eine Gesamtschaltung der Teilerstufen mit Verstärkern und Kalibriermöglichkeit sowie

Figur 3 Einzelheiten des Kalibrierteils.

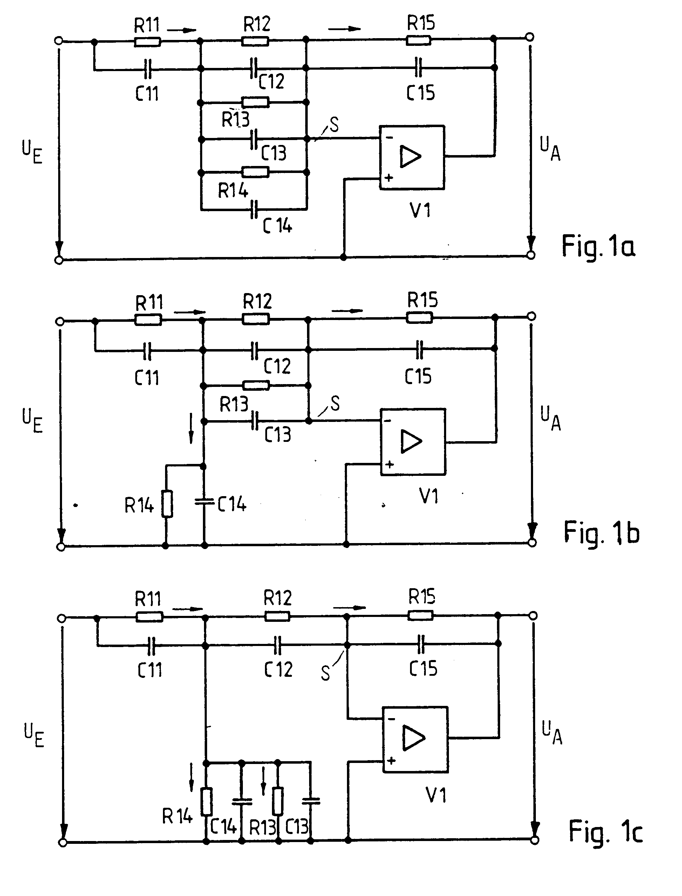

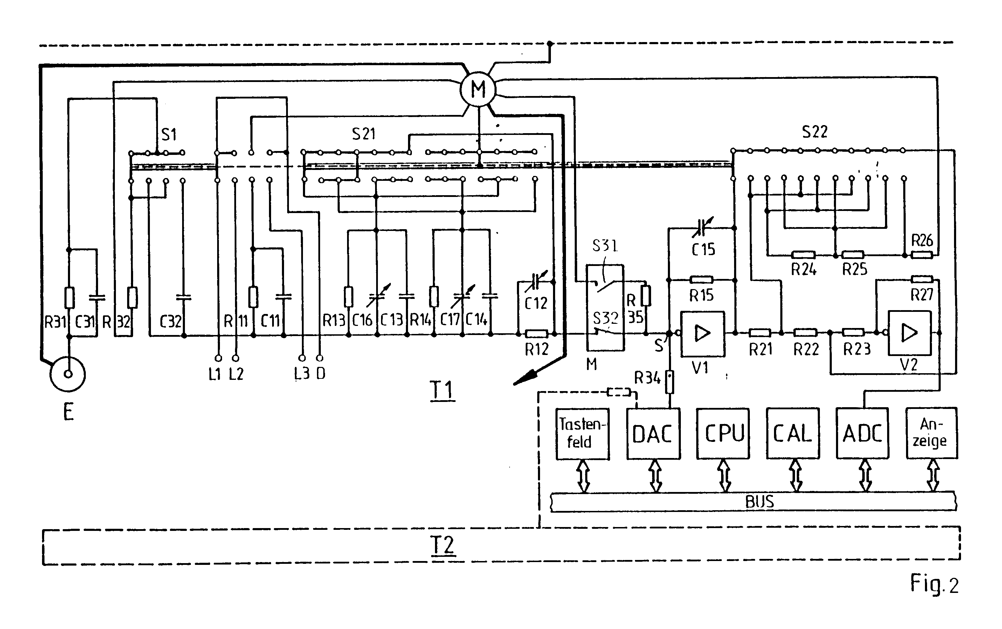

Die nachfolgende Beschreibung eines bevorzugten Ausführungsbeispiels erfolgt anhand der Figuren, wobei bezüglich des Prinzips des Eingangsteilers mit nachgeschaltetem potentiometrisch beschalteten Operationsverstärker auf die Figuren 1a bis c verwiesen wird, während die weitere Details aus Figur 2 hervorgehen.

In den Figuren 1a bis 1c ist ersichtlich, wie die auf einen komplexen Eingangswiderstand (R11 parallel zu C11) folgenden Widerstands/Kondensatorkombinationen R13/C13 und R14/C14 - je nach einzuschaltenden Meßbereich einzeln oder gemeinsam - entweder zum invertierenden Eingang (Summenpunkt S) des Operationsverstärkers V1 hin parallel zu einer Kondensatorkombination R12/C12 geschaltet sind oder aber mit dem Summenpunkt S mit dem Ein- bzw. Ausgangsbezugspunkt und dem Nicht-Invertierenden Eingang (+) des Verstärkers V1 verbunden sind. Eine Widerstandskondensatorkombination R15/C15 (alle Widerstands/Kondensatorkombinationen in Parallelschaltung) verbindet den Summenpunkt S mit dem Ausgang des Verstärkers V1.

Da der Summenpunkt S und der Bezugspunkt für Ein- und Ausgangssignal sich potentialmäßig praktisch nicht unterscheiden, können diese Punkte bezüglich des Eingangssignals als zusammengefaßt angesehen werden. Die Verhältnisse vom Eingang her gesehen ändern sich durch diese Umschaltungen nicht. Es ändert sich aber das Verstärkungsverhältnis ($U_A/U_E$), welches durch das Verhältnis der Widerstände vom Ausgang zum Summenpunkt S hin - bezogen auf die Widerstände vom Eingang zum Summenpunkt S hin - bestimmt wird. Die Streupotentiale werden durch die Umschaltungen ebenfalls nicht beeinträchtigt.

Nunmehr soll das in Figur 2 dargestellte detaillierte Ausführungsbeispiel beschrieben werden. Über eine geschirmte koaxiale Eingangsbuchse, beispielsweise eine BNC-Buchse, wird das Eingangssignal der Schaltung zugeführt. Diese ist zunächst mit dem Sicherheitsvorwiderstand R31 verbunden. Dieser Vorwiderstand muß einen großen Wert aufweisen, spannungsfest und hochgenau sein.

Parallel dazu geschaltet ist der Beschleunigungseingangskondensator C31, der ebenfalls aus Sicherheitsgründen hochspannungsfest sein muß. Er wird vorteilhafterweise in einer Mehrlagenkarte durch zwei Kondensatorbelege gebildet, die in ihrer Fläche entsprechend im Innern der Mehrschichtkarte durch zwei auf verschiedenen Ebenen befindlichen und durch das Basismaterial als Dielektrikum getrennten Metallbelegen dargestellt werden. Man verwirklicht auf diese Weise den sonst sehr teuren Spezialkondensator in einer hoch sicheren Ausführung ohne zusätzliche Kosten.

Außerdem müssen die Bauelemente an diesem unmittelbaren Eingangsteil entsprechende Kriechstrekken aufweisen, desgleichen auch der Abstand der Befestigungsbohrungen in der Leiterkarte.

Dem Vorwiderstand nachgeschaltet ist der Betriebsartenschalter (BAS) des Schalters S1. Er dient auch als Einschalter des Gerätes.

In der ersten, der gezeichneten ganz linken Schalterstellung des BAS (OFF) ist das Gerät ausgeschaltet, der Eingangswiderstand des Gerätes wird aus dem Widerstand R31 und dem in Reihe geschalteten Widerstand R32 gebildet.

In der zweiten Schalterstellung des BAS von links, in der Position DC (DIRECT CURRENT), wird der Vorwiderstand über den Schalterbügel mit dem Eichteiler verbunden. Gleichzeitig wird mechanisch parallel ein weiterer Schalterbügel im BAS-Code-Schalter bewegt, der das Gerät einschaltet.

In der dritten Schalterstellung des BAS von links, der Stellung GD (GROUND) wird der Vorwiderstand R31 wie in der Schalterstellung OFF mit dem Ergänzungswiderstand R32 zum Eingangswiderstand zusammengeschaltet, während gleichzeitig die zweite Schalterbrücke des BAS den Eingang des Eichteilers über einen dem Eingangswiderstand R32 äquivalenten Widerstand R32 an die zentrale Meßmasse legt, um in der Stellung GROUND einen auf Masse liegenden Meßgeräte-Eingang zu simulieren.

In der vierten Schalterstellung des BAS von links schließlich, der Stellung AC (ALTERNATING CURRENT) wird der Vorwiderstand R32 über einen spannungsfesten Koppelkondensator C32 an die Eichteilerschaltung angeschlossen. Gleichzeitig wird mechanisch parallel ein weiterer Schalterbügel im BAS-Code-Schalter bewegt, der diese Stellung an die digitale Auswertung der Schalterstellung meldet.

Da der Koppelkondensator in einem hochohmigen Schaltungsteil arbeitet, wird die Forderung nach sehr niedriger Koppelzeitkonstante erfüllt.

Die Verbindung des Vorwiderstandes mit der Eichleitung gestattet es nun, über den Meßbereichsdekadenschalter (S21) die Widerstände R13 und R14 so mit virtueller Masse oder reeller Masse zu verbinden, daß sich die in Tabelle genannten Verstärkungen für den potentiometrisch beschalteten Videovorverstärker in den Schalterpositionen 1 bis 11 ergeben, wie es theoretisch bei der Erläuterung des Eichteilers beschrieben und in Kombination mit dem zweiten Stufenmeßbereichsschalter notwendig ist.

Den Stromteilerwiderständen R13, R14, R15 sind jeweils die Kondensatoren C13 und C16, C14 und C17 bzw. C15 parallel geschaltet. Sie bilden die Kompensationskondensatoren, die im vorherigen Abschnitt erläutert wurden. Die Kombination jeweils aus einem Trimm- und einem Festkondensator verbessert die Einstellbarkeit und den Temperaturkoeffizienten. Der MBSD wird aus einem Zwei-Ebenen-Schalter mit elf Stufen gebildet.

Zwei Schalterbrücken verbinden in den ersten Schalterpositionen die Stromteilerwiderstände über den Kalibrationsschalter mit dem potentiometrischen Eingang des Vorverstärkers V1. Von der fünften Position an verbindet zunächst der zweite Kurzschlußbügel den Widerstand R14 mit der zentralen Meßmasse, während der Widerstand R13 noch am potentiometrischen Eingang liegt, um dann von der achten Schalterposition an bis zur offenen Position beide Widerstände mit Meßmasse zu verbinden. Die Aufgliederung der Schalterkontakte, die den Massekontakten gegenüberliegen in der gezeichneten Konfiguration ermöglicht es, mit zwei Schleiferbrücken alle Varianten der geforderten Konjunktionen zu erreichen.

Wie bereits erläutert, ist der Summenpunkt bezogen auf das System ein sehr wesentlicher Punkt der gesamten Analogschaltkreise. Er dient nicht nur als virtuelle Masse für die Stromteilerschaltung, sondern stellt gleichzeitig folgende wichtige Systempunkte dar:

Summenpunkt für die Zuführung des vom DAC erzeugten Korrekturstromes zur automatischen Nullpunktkorrektur am Eingangspunkt des gesamten aktiven Verstärkerzuges.

Summenpunkt für die Zuführung des vom DAC erzeugten Korrekturstromes zur Nullpunktverschiebung, zur Erzeugung einer elektronischen Kompensationsspannung für ein mit einer Gleichspannung unterlegtes Wechselspannungssignal (elektronische AC-Kopplung).

Meßpunkt der Offsetspannung des Operationsverstärkers V1 mit Hilfe des Simulationswiderstands R35, der über den durch den mikroprozessorgesteuerten Schalter M in dieser Meßphase gegen die zentrale Meßmasse gelegt wird.

Summenpunkt für die Zuführung des von der Eichleitung kommenden Signalstroms über den Schalter S1.

Dieser Summenpunkt des potentiometrisch beschalteten Verstärkers dient also der automatischen Kalibration des gesamten analogen Systems. Geht man von der Tatsache aus, daß die vor dem Summenpunkt befindliche Betriebsarteneinstellung und auch der Meßteiler passive Netzwerke aus Präzisionselementen mit niedrigem Temperaturkoeffizienten darstellen, die eine erhebliche Langzeitstabilität und Zuverlässigkeit aufweisen, erlaubt die Autokalibration die permanente, d.h. im Betrieb vor jeder Meßfolge des intermittierenden Meßbetriebes oder auch in anderen Fällen vor jedem einzelnen Meßzeitpunkt (vor jeder Probeentnahme des Samplevorganges) eine automatische Nullpunktkorrektur und sogar eine Eichung der Linearität des gesamten Systems einschließlich des Analog-Digital-Wandlers. Es ist auch möglich, mit diesem System vom Mikroprozessor aus über ein - beispielsweise 12 bit- - Signal den DA-Wandler (DAC) so zu steuern, daß dem Signaleingang schrittweise innerhalb des gesamten Übertragungsbereichs Gleichspannungsschritte zugeführt werden, so daß über den Analog-Digital-Wandler Bit für Bit dem Mikroprozessor zum Vergleich und damit zur Ablage einer Eichtabelle angeboten wird. Die Autokalibration geht im einzelnen wie folgt vor sich:

Phase I: Der Mikroprozessor legt einen Schalter S32 in Arbeitslage und mißt die Offset-Spannung über den Widerstand R35.

Phase II: Da dem Mikroprozessor über die BAS-Codierung bekannt ist, welcher Meßbereich eingeschaltet ist, kennt er den Quellwiderstand der Eichleitung vom Summenpunkt aus gesehen. Somit kann er mit dem Meßwert der Phase I die Offset-Spannung ausrechnen, die dem jeweiligen Quellwiderstand entspricht und diese über den DAC in der Phase III zu führen.

Phase III: Der Mikroprozessor führt bei geöffnetem Schalter S31 über den DAC dem Operationsverstärkerzug, über den ADC schrittweise Eichsignale wieder dem Mikroprozessor in digitalisierter Form zu. Der Mikroprozessor legt eine entsprechende Eichtabelle ab, um die in Phase IV eintreffenden zu messenden Signale kalibrationsgerecht bewerten zu können.

Phase IV: Der Schalter S32 wird geöffnet, der Schalter S31 geschlossen und die Meßphase kann beginnen. Während der Meßphase wird über den DAC die bei der Phase II ermittelte Nullpunktkorrekturspannung zugeführt, um das Fester des ADC optimal nutzen zu können.

Die Einführung des Autokalibrationssystems hat zwei entscheidende Vorteile. Einmal konnte damit erreicht werden, daß die Nullpunktstabilität und Temperaturdrift der gesamten analogen Stufen gewährleistet werden kann und demzufolge der Aufwand für diese Stufen in Grenzen bleiben kann. Zum Beispiel brauchen im zweiten Eichteiler keine Präzisionswiderstände verwendet werden. Die Temperaturdrift der Halbleiterbauelemente und der passiven Bauelemente spielt keine erhebliche Rolle mehr. Der entscheidende Vorteil liegt jedoch in der Langzeitstabilität und der damit erreichten hohen Zuverlässigkeit, die bisher bei Niedrigpreisgeräten dieser Größenklasse undenkbar war.

Abgesehen von diesen wertanalytischen und zuverlässigkeitsorientierten Aspekten gibt es noch eine ganze Reihe von Gründen, die dieses Systemprinzip für Spezialanwendungen prädestinieren. Zum Beispiel dann, wenn ein Hochgeschwindigkeits-Digital-Analog-Wandler Verwendung findet.

Der in Figur 2 wiedergegebene Eingangsteil (für einen Kanal) soll nachfolgend im einzelnen beschrieben werden.

Das am Eingang E erscheinende analoge Signal wird über einen hochohmigen Sicherheitsvorwiderstand R31 mit einem parallelen Sicherheitskondensator C31 dem Betriebsartenschalter S1 zugeführt. Der Betriebsartenschalter gestattet es, die Betriebszustände "Gleichspannungskopplung (DC)", "Wechselspannungskopplung (AC)", "Eingang kurzgeschlossen (GROUND)" mittels eines mechanischen Schiebeschalters auszuwählen. Gleichzeitig kann über diesen Schalter das Gerät mit der Schalterstellung "Aus" bezüglich seiner Versorgungsspannung ein- oder ausgeschaltet werden - der entsprechende Kontaktsatz ist in der Darstellung aus Gründen der Übersichtlichkeit fortgelassen worden.

Der Betriebsartenschalter besteht aus einem mechanisch parallel geschalteten Codierschalter, der dem nachgeschalteten Mikrocomputer des digitalen Verarbeitungsteils die jeweilige Position des Schaltschiebers durch die Verbindung einer Leitung "D" mit einer von drei weiteren Leitungen L1 bis L3 meldet. Die Meldung der vierten Position besteht darin, daß keine Verbindung vorhanden ist.

Außer dem Betriebsartenschalter ist (pro Kanal) noch ein Meßbereichsschalter S21/S22 vorgesehen, der die Anpassung der Eingangssignalamplitude an die Pegelverhältnisse der weiteren Stufen erlaubt. Der Meßbereichsschalter besteht aus je zwei Hauptteilen S21 und S22. Er wird aus einem elfstufigen Mehrfachschiebeschalter gebildet, dessen erster Teil aus dem dekadischen Meßbereichsschalter S21 besteht. Dieser dient dazu, die Verstärkung und Abschwächung der Eingangssignale über durch den Schalter veränderbare Widerstandsnetzwerke bezüglich eines Summationspunktes vorzunehmen.

Die folgende Tabelle zeigt zur Meßbereichsstellung MBS, dem Vertikalkoeffizienten n die zugehörigen Werte für die Bezugsspannung Yb, die Dezimalabschwächung a1, den Verstärkungsfaktor v1 der Trennstufe, deren nominelle Ausgangsspannung Ua1, die Abschwächung a2 vor dem Kanalverstärker und die jeweilige Verstärkung v2 des Kanalverstärkers.

EP 0 252 085 B1

| MBS (V/DIV) | Yb (V) | a1 | v1 | Ua1 (V) | a2 | v2 |
|---|---|---|---|---|---|---|
| 0,01 | 0,06 | 1 | 5 | 0,30 | 1 | 7,8125 |
| 0,02 | 0,12 | 1 | 5 | 0,60 | 1 | 3,90625 |
| 0,05 | 0,30 | 1 | 5 | 1,5 | 0,4 | 3,90625 |
| 0,1 | 0,6 | 1 | 5 | 3,0 | 0,2 | 3,90625 |
| 0,2 | 1,2 | 0,05 | 10 | 0,6 | 1 | 3,90625 |
| 0,5 | 3,0 | 0,05 | 10 | 1,5 | 0,4 | 3,90625 |
| 1,0 | 6,0 | 0,05 | 10 | 3,0 | 0,2 | 3,90625 |
| 2,0 | 12 | 0,05 | 1 | 0,6 | 1 | 3,90625 |
| 5,0 | 30 | 0,05 | 1 | 1,5 | 0,4 | 3,90625 |
| 10,0 | 60 | 0,05 | 1 | 3,0 | 0,2 | 3,90625 |
| 20,0 | 120 | 0,05 | 1 | 6,0 | 0,1 | 3,90625 |

Die Ausgangsspannung beträgt einheitlich 2,345 V.

Die Widerstände und Kondensatoren der Teilerschaltungen entsprechen bezüglich ihrer Bezeichnungsweise denjenigen der vorangehenden Prinzipdarstellungen. Weitere den Teilerkondensatoren parallelgeschaltete Trimmer sind bezüglich des Bezugszeichens mit einem zusätzlichen "'" versehen.

Mit Hilfe eines durch Analogschalter gebildeten Kalibrationsmultiplexers M kann der Analogsignaleingang E vom Summationspunkt getrennt und über einen Digital-Analog-Wandler DAC von der CPU des nachgeschalteten Mikrocomputers gesteuert werden. Dabei wird dem auf den Summationspunkt S über den Widerstand R34 schrittweise ein Gleichspannungssignal zugeführt. Das Gleichspannungssignal wird somit am Eingang der Verstärkerkette eingespeist, passiert die gesamte Verstärkerkette und wird über einen AD-Wandler an dem Mikrocomputer zur Auswertung als digitales Signal zurückgeführt. Da dieser die SOLL-Signale selbst generiert hat, kann er die eintreffenden IST-Signale in einer Eichtabelle ablegen und so bei dem folgenden Meßvorgang, bei dem der Kalibrationsmultiplexer wieder die Signalquelle aufschaltet, eine gegebenenfalls notwendige Korrektur bei der Bewertung der eintreffenden IST-Signale nach der abgelegten Korrekturtabelle vornehmen.

Den entscheidenden Einfluß auf die Vielseitigkeit des Gerätes hat der Summationspunkt S. Er wird durch die virtuelle Masse eines potentiometrisch beschalteten Gleichspannungs-Breitbandverstärkers gebildet. An ihm können die aus dem DA-Wandler stammenden Gleichspannungsignale zur automatischen Nullpunktkorrektur und zur Autokalibration angeschaltet werden. Gleichzeitig dient er als virtuelle Masse für den Verstärker V1 mit der über den dekadischen Meßbereichsschalter S21 geschaltete Eichleitung.

Der Meßvorverstärker V1 wird durch einen aus diskreten Halbleiterbauelementen aufgebauten Gegentaktbrückenverstärker gebildet und verstärkt im Zusammenwirken mit dem als Stromteiler aufgebauten, einen Eichteiler darstellenden, dekadischen Meßbereichsschalter in potentiometrischer Beschaltung das Eingangssignal. Er trennt auf diese Weise die Eichleitung, die eine dekadische Stufung der gesamten Verstärkung von 5-fach, 0,5-fach, 0,05-fach erlaubt, von dem dem Verstärker V1 nachgeschalteten Stufenschalter.

Um die große Zahl von Meßbereichen ohne zu großen Aufwand im hochohmigen Teil der als Eichleitung gebildeten Eingangsschaltung bewältigen zu können, werden in den einzelnen 11 Meßbereichsstufen die dekadischen Teilungen durch den dekadischen Meßbereichsschalter erzeugt. In den dazwischenliegenden Pegelanpassungsstufen 1; 0,5; 0,2 wird die zusätzliche Teilung nach dem ersten einen Trennverstärker bildenden Meßvorverstärker V1 vorgenommen, da mit dem Ausgang dieses Verstärkers bereits eine niederohmige Quelle vorhanden ist und somit die Stufenteilerwiderstände, durch einen Stufenschalter S22 angewählt werden, die ohne Kompensationskondensatoren auskommen.

Der Stufenschalter S22 ist demzufolge zwischen den Meßvorverstärker V1 und einem nachfolgenden Meßverstärker V2 geschaltet und erlaubt die Abschwächungen mit den Faktoren 1; 0,5; 0,2. Parallel zum Stufenschalter S22 ist eine - in der Zeichnung nicht dargestellte - weitere Kontaktserie des Stufenschiebeschalters S22 vorgesehen, welche die von dem DA-Wandler erzeugten Gleichspannungs-Ausgangssignale an die jeweils der Stufenschalterstellung entsprechenden erforderlichen Spannungspegel (respektive Strompegel) am Eingang des Summationspunktes anpaßt.

Dem Stufenschalter nachgeschaltet ist der Meßverstärker V2, der wiederum als breitbandiger Gleichspannungsverstärker ausgelegt ist und den Gesamtpegel gemäß den Erfordernissen des am Eingang des Parallel-AD-Wandlers Pegelfensters verstärkt. Das verwendete Pegelfenster hat eine Breite von etwa 2,5 V.

Der Teiler der den Verstärker V2 umfassenden Stufe wird - in Zusammenwirken mit dem Teiler der ersten Stufe - durch den Schalter S2 auf andere Weise beeinflußt. Die Verstärkerstufe V2 ist zwar ebenfalls potentiometrisch beschaltet - es entfallen aber bereits den Wirkwiderständen parallel geschaltete Kapazitä-

7

EP 0 252 085 B1

ten. Eine zwischen den Widerständen R22 und R23 befindliche Anzapfung ist mit den zusammengefaßten Anschlüssen einer Seite des Schiebeschalters S22 verbunden, wobei dieser Punkt entsprechend der zunehmenden Verminderung des Verstärkungsfaktors des Verstärkers V2 zunächst mit dem Ausgang des Verstärkers V1, anschließend mit dem Verbindungspunkt der beiden Widerstände R21 und R22 und dann mit Querwiderständen verbunden wird, welche zusammen mit den Widerständen R21 und R22 einen Spannungsteiler zum Bezugspotential hin bilden, von dem der Widerstand R23, der zusammen mit dem Widerstand R27 den Verstärkungsfaktor des Operationsverstärkers V2 bestimmt, seine Eingangsspannung erhält. Je nach dem gewählten Verstärkungsfaktor wird der Verbindungspunkt der Widerstände R22 und R23 an unterschiedliche Anzapfungen der aus den Widerständen R24, R25 und R26 gebildeten Serienschaltung gelegt. Damit lassen sich durch entsprechende Einstellung des aus den Schaltern S21 und S22 bestehenden Teilers die für den vorgesehenen Eingangsspannungsbereich des Gerätes notwendigen Spannungsheraufsetzungen bzw -verminderungen erzielen.

Um die Signale mit hoher Bandbreite auswerten zu können, findet ein nachgeschalteter Parallel-Analog-Digital-Wandler mit möglichst hoher Probenentnahmefrequenz (Sampling-Rate) Verwendung. Dieser sogenannte "Flash-Wandler" wird am Eingang durch eine parallel geschaltete, über einen Referenzspannungsteiler quantifizierte Kette von Hochgeschwindigkeitskomparatoren gebildet. Zum Sample-Zeitpunkt übernimmt jener der Komparatoren (bei einem 8-bit-Wandler sind das 256 Komparatoren) die Signalerkennung, dessen Referenzspannungswert jeweils gerade über- oder unterschritten wird. Eine den Komparatoren nachgeschaltete Kodierschaltung gibt den erkannten digitalen Wert, beispielsweise in einer 8 bit breiten binären Kodifikation weiter, die das Signal im Takt der Sampling-Frequenz am Ausgang des Analog-Digital-Wandlers zur Verfügung stellt.

Die vom Analog-Digital-Wandler erzeugten digitalen Daten werden von der CPU des nachgeschalteten Microcomputers verwaltet. Die 8-Bit-CPU enthält ein On-Board RAM, ROM und einen Oszillator sowie Timereingänge und serielle Schnittstellen.

Die CPU dient als Zentralcomputer, um alle Befehle, die von dem Tastenfeld eingehen, dem im internen oder auch externen Programmspeicher enthaltenen Programm entsprechend zu bearbeiten, um die von dem Hochgeschwindigkeitsregister angebotenen Signale auszulesen und diese entsprechend den verschiedensten Vorschriften auszuwerten, umzurechnen, in den Speichern abzulegen, mit anderen Signalen zu vergleichen, Analysen vorzunehmen und sie schließlich darstellungs- und schnittstellengerecht einer Bildschirmanzeige oder einem Graphikprozessor, einem Drucker oder der Funktionsgenerator-Ausgangsschnittstelle oder anderen Schnittstellenprozessoren über den BUS zu übergeben. Die Daten für die Gleichspannungskompensation und die Calibrierung werden in einem mit "Cal" bezeichneten Speicher abgelegt. Hier befinden sich auch die Tabellen, welche die bitweise Calibrierung bewerkstelligen.

Bemerkenswert bei der beschriebenen Schaltungsanordnung ist, daß der zweistufige Schiebeschalter bezüglich seiner Kontakte stets denjenigen elektrischen Bauelementen, deren Kontakte geschaltet werden sollen, direkt benachbart ist. Zwischen den Kontakten der beiden in Betätigungsrichtung des Schalters aufeinanderfolgenden Stufen ist auf der Platine ein Verstärker vorgesehen, wobei der durch den Verstärker erzeugte räumliche Abstand von einem Betätigungselement des Schalters überbrückt wird.

In Betätigungsrichtung dem Teilerschalter vorgeschaltet ist der Betriebsartenschalter, welcher vom Teilerschalter unabhängig - konstruktiv aber entsprechend - ausgeführt ist.

Durch eine derartige Schaltung läßt sich die Eingangsschaltung eines Oszillographen mit räumlich optimal kurzen Verbindungswegen aufbauen, so daß die gegenseitigen Signalbeeinflussungen gering gehalten werden können. Die Schaltung eignet sich auch insbesondere für einen zweikanaligen symmetrischen Aufbau, sei es, daß die Schiebeschalter entlang der Außenkante der Platine mit U-förmigen Kontaktelementen wirken oder aber im Zentralbereich einer Platine nebeneinander angeordnet sind. Bei der Anordnung entlang der Außenkanten bietet sich zudem noch der Vorteil, daß die Entkopplung der beiden Kanäle günstig realisierbar ist, so daß eine gegenseitige Signalbeeinflussung praktisch nicht stattfindet, insbesondere wenn im die beiden Kanäle trennenden Bereich noch solche Schaltungselemente angeordnet sind, welche beiden Kanalverstärkern zugeordnet sind, wie beispielsweise die Stromversorgungsschaltung oder ein nach einer Digital-Analog-Wandlung die Signalverabeitung weiterführender Prozessor.

Eine derartige Bauweise ermöglicht dann - bei entsprechender Miniaturisierung der übrigen Bauelemente - die Anordnung einer vollständigen Oszillographenschaltung auf einer Platine und bildet somit eine wesentliche Voraussetzung zur Schaffung eines in der Hand haltbaren Meßgerätes zur Verarbeitung von elektrischen Eingangssignalen stark unterschiedlicher Amplitudenbereiche. Dabei ist zu berücksichtigen, daß die Größe einer elektrischen Schaltungsplatine - auch wenn sie in Multilayer-Technik ausgeführt wird - im wesentlichen durch die Anzahl der dort unterzubringenden Leiterbahnen bestimmt wird. Eine Verminderung der Abmessungen läßt sich also im wesentlichen dann erzielen, wenn von vorn herein durch die konstruktive Anordnung Maßnahmen getroffen werden, um die Länge der Leiterbahnen generell zu verkürzen. Eine derartige Maßnahme fördert auch die übrigen Eigenschaften des Gerätes, da verringerte Verluste und gegenseitige Signaleinstreuungen auftreten. Auf diese Weise werden weitere, die Qualität des zu bearbeitenden Signals wiederherstellende Elemente eingespart, was insgesamt zu einer weiteren Verminderung der Baugröße führt.

In Figur 2 sind neben dem bisher beschriebenen Verstärkerzug die weiteren zu einem Digital-Oszilloskop gehörigen Baugruppen blockschaltungsmäßig wiedergegeben, wobei die digitalen Signale vom Tastenfeld, dem Digital-Analog-Wandler (DAC), dem Prozessor mit Speicher (CPU), der Eichanordnung (CAL), dem Analog-Digital-Wandler (ADC) und der LCD-Anzeige an einem gemeinsamen BUS in Verbindung stehen. Der weitere auf der gegenüberliegenden Seite der entsprechenden Leiterplatine angeordnete Verstärker/Teiler-Zug ist ebenfalls durch einen rechteckigen Block repräsentiert. Die Anordnung der Bauelemente erfolgt spiegelbildlich zu der Darstellung im oberen Bereich der Figur. Für den Fall der Anordnung der Schiebeschalter S1, S21 und S22 am Rand der Platine ist das Zeichnungsblatt um die eine Abschirmung repräsentierende gestrichelte Linie, welche in der Mitte der Kontakte der Schalter entlang führt, gefaltet zu denken. Damit ergibt sich ein anschauliches Bild der Anordnung der Kontakte der Schalter am Rande einer beidseitig mit Schaltkontakten versehenen Platine, wobei die beweglichen Kontaktelemente entsprechend der realen konstruktiven Ausführung U- bzw. Omega-förmig sind.

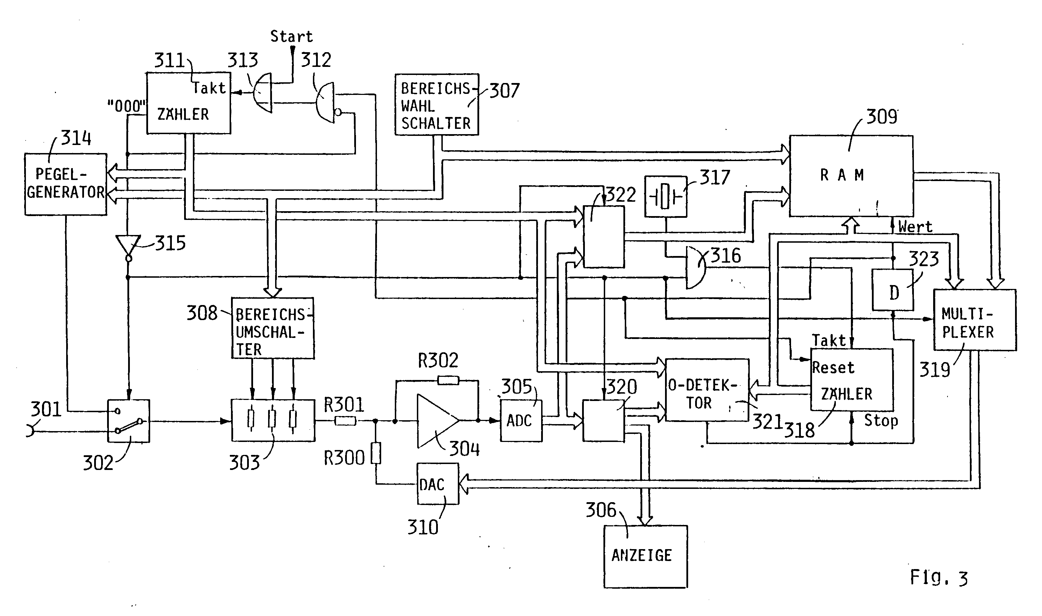

In Figur 3 ist ein Ausführungsbeispiel der Anordnung zum Calibrieren näher dargestellt.

Während im Meßbetrieb vom Meßeingang 301 über einen Umschalter 302 das Eingangssignal im Analogverarbeitungsteil über eine Pegelanpassung 303 mit umschaltbaren Widerständen zu der nachgeschalteten Operationsverstärkerschaltung 304 über einen Analog-Digital-Wandler (ADC) 305 zu einem Verarbeitungs- und Anzeigeteil 306 gelangt, wo eine Anzeige des erfaßten Analogmeßwert mit digitalen Mitteln erfolgt.

Der Operationsverstärker 304 weist Widerstände R301 und R302 auf, welche in potentiometrischer Beschaltung die Verstärkung bestimmen, wobei die Umschaltmittel 303 bevorzug den Widerstand R301 zugeschaltet werden bzw. diesen Wert selbst verändern, wie es weiter oben dargestellt ist.

Um Verarbeitungsfehler im Analogverarbeitungszug zu kompensieren, sofern sie auf Gleichspannungs- oder Linearitätsfehlern beruhen, wird für die einzelne Meßbereiche regelmäßig eine Calibrierung durchgeführt. Diese Calibrierung wird zwischen einzelnen Meßzyklen vorgenommen und durch ein Signal "Start" ausgelöst, welches vom System entsprechend erzeugt wird. Die Calibrierung erfolgt jeweils für den durch einen Bereichswahlschalter 307 eingestellten Meßbereich, wobei der Bereichswahlschalter ein Digitalsignal abgibt, welches eine Umschaltung (Block 308) aktiviert, die die einzelnen im Block 303 enthaltenden Widerstände so einstellt, daß über den Operationsverstärker 304 das Analogsignal entsprechend dem gewünschten Signalpegel beeinflußt wird. Das Ausgangssignal des Bereichswahlblocks 307 bildet gleichzeitig die digitale Adressierung eines RAMs 309, welches in digitaler Form die Korrekturwerte aufnimmt, die eine Kompensation in Richtung der gewünschten Calibrierung bewirken. Das Ausgangssignal des Bereichswahlschalters adressiert jeweils Adressen der Bereiche im RAM 309. Dieses Signal enthält dabei also die höherwertigen Bits des Gesamtadressensignals.

Das im adressierten Speicherplatz des RAMs enthaltene digitale Signal wird einem Digital-Analog-Wandler 310 zugeführt, dessen analoges Ausgangssignal über einen Widerstand dem virtuellen Massepunkt des Operationsverstärkers 304 zugeführt wird. Als wesentlicher Vorteil ergibt sich somit, daß der Korrekturwert stets jeweils nur dem relativen Fehler entspricht und vom gewählten Bereich unabhängig ist. Damit wird die in den digitalen im RAM 309 gespeicherten Werten enthaltene Information optimal genutzt. Und ermöglicht eine direkte Aussage bezüglich der relativen Abweichung.

Ist ein bestimmter Meßbereich eingestellt, wird ein Calibriervorgang für diesen Meßbereich durch das Eingangssignal "Start" ausgelöst. Der Ausgang "000" eines Zählers 311 sperrt im "HIGH"-Zustand über einen invertierenden Eingang des UND-Gatters 312 die über dessen anderen Eingang und ein ODER-Gatter 313 an seinen Takteingang gelangenden Signale. Bei der Aktivierung über den Eingang "Start" wird der Zähler in den Zustand "001" gesetzt, so daß das Signal am entsprechenden Ausgang in den Zustand "LOW" übergeht. Dadurch wird der Schalter 302 umgesetzt, so daß der Analogverarbeitungszug mit dem Ausgangssignal eines Pegelgenerators 314 verbunden ist, der in Stufen Signale erzeugt, welche sich über den gesamten Meßbereich erstrecken. Der Pegelgenerator 314 wird insoweit ebenfalls vom digitalen Ausgangssignal des Bereichswahl-Blocks 307 beeinflußt. Das am Ausgang des Zählers erscheinende Signal "000" gelangt über einen Inverter 315 nicht nur zum Umschalter 302, sondern auch zu einem UND-Gatter 316, welches die Taktsignale eines Oszillators 317 zu einem weiteren Zähler 318 gelangen läßt. Die Ausgangssignale dieses Zählers 318 werden einerseits an den Eingang des RAMs 309 übertragen und dort gegebenenfalls auf ein entsprechendes Signal hin eingespeichert bzw. zu einem Multiplexer 319, der über einen entsprechenden Steuereingang im Betriebzustand "calibrieren" das entsprechende digitale Signal zu dem Digital-Analog-Wandler 310 gelangen läßt, der das erwähnte Kompensationssignal erzeugt. Der Zähler 318 zählt von einem Anfangssignalzustand solange weiter bis das vom Analog-Digital-Wandler 305 über einen weiteren Multiplexer 320 zu einem Null-Detektor 321 geführte Signal den Wert "null" anzeigt.

Der Multiplexer 320 wird im Calibrierungszustand zu diesem Null-Detektor 321 hin durchgeschaltet, während im Meßbetrieb die Ausgangssignale des Analog-Digital-Wandlers zur Anzeige 306 geleitet werden.

Der Digital-Analog-Wandler ist so eingestellt, daß ein Ausgangssignal "null" in etwa in der Mitte des Bereichs der Digitalwerte liegt, die den Digital-Analog-Wandler ansteuern. Der Zähler 318 erzeugt damit während seines Durchlaufs eine von negativen zu positiven Werten hin verlaufende Kombinationsspannung. Das Ausgangssignal "null" des Null-Detektors, welches anzeigt, daß der korrekte Anzeigewert durchlaufen wurde, hält den Zähler 318 an und sorgt - mittels eines über ein D-Glied 320 verzögerten Impulses - über den Eingang "Speichern" des RAMs 309 dafür, daß der erreichte Wert des Zählers im adressierten Speicherplatz des RAMs festgehalten wird. Bei dem ersten vom Pegelgenerator 314 abgegebenen Wert handelt es sich um den Wert "null", so daß in diesem Fall zunächst die für die Nullpunktkompensation erforderliche Einstellung des Digital-Analog-Wandlers 310 festgehalten wurde. Das Signal am Aisgang des D-Glieds 320 setzt über den Eingang "Reset" in Zähler 318 zurück und über den Takteingang des Zählers 311 diesen um einen Wert voran. Dadurch wird der Pegelgenerator 314 auf die erste Stufe gesetzt, so daß dieser ein analoges Signal von einem bestimmten Bruchteil des maximalen Eingangssignals abgibt.

Sein Endzählerstand entspricht dabei dem maximalen Eingangssignalwert des betreffenden Meßbereichs. Das Ausgangssignal des Zählers gelangt außerdem zum RAM 309 und bildet dort die niederwertigeren Bits der Adresse, so daß mit fortschreitendem Stand des Zählers 311 die Zwischenwerte des RAMs 309 durchlaufen werden. Weiterhin wird der digitale Null-Detektor mit dem aktuellen Wert des Zählers 311 beaufschlagt, wobei dieser Wert von dem Wert abgezogen wird, der vom Multiplexer 320 zum Null-Detektor 321 gelangt. Damit gibt der Null-Detektor ein Ausgangssignal ab, sobald die beiden Werte gleich sind - das Ausgangssignal des Analog-Digital-Wandlers also dem Erwartungswert entspricht.

Auf diese Weise wird ein bestimmter Meßbereich punktweise abgetastet und eine Korrekturtabelle im RAM 309 abgelegt, so daß der Übertragungsbereich der Analogstrecke durch die im Meßbetrieb durch aus dem RAM 309 erzeugte Korrektursignale linearisiert wird. Die niederwertigen Bits des RAMs 309 werden durch den entsprechend eingestellten Multiplexer 322 im Meßbetrieb durch das Ausgangssignal des Analog-Digital-Wandlers 305 adressiert, so daß die Ermittlung des Korrekturwertes durch den Meßwert selbst erfolgt. Angezeigt wird der sich nach mehreren Meßzyklen einstellende Wert, da der Meßwert sich durch die Korrekturwerte gegebenenfalls noch verändert.

Bei einer anderen Ausführung der Erfindung wird lediglich eine Nullpunktkorrektur über dem Digital-Analog-Wandler 310 durchgeführt und für den jeweiligen Meßbereich beibehalten, während die anderen ermittelten Korrekturwerte, die im RAM 309 enthalten sind, nicht zu einer Veränderung des Ausgangssignals des Digital-Analog-Wandlers 310 führen, sondern direkt den in der Anzeige 306 wiedergegebenen Wert arithmetisch berichtigen, wobei bei der Addition des entsprechend dem Meßbereich im RAM adressierten Wert der Speicherinhalt jeweils noch arithmetisch digital mit dem Ausgangssignal der Bereichswahl 307 verknüpft wird.

**Patentansprüche**

1. Signalverarbeitungsgerät mit Pegelanpassungsschaltung, insbesondere Breitbandoszilloskop, mit einem Operationsverstärker (V1), dessen Verstärkungsfaktor durch das Verhältnis eines ersten Widerstandes (R12/C12) zwischen Signaleingang und invertierendem Eingang des Operationsverstärkers - der virtuellen Masse - sowie eines zweiten Widerstandes (R15/C15) zwischen invertierendem Eingang des Operationsverstärkers und Signalausgang bestimmt wird, wobei die Widerstände gegebenenfalls komplex sind,
   **dadurch gekennzeichnet,**
   daß zum ersten Widerstand (R12/C12) mindestens ein Parallelwiderstand (R13/C13, R14/C14) vorgesehen ist, dessen erster Anschluß fest mit dem Signaleingang (E) oder einem Verbindungspunkt mehrerer den ersten Widerstand bildender Teilwiderstände verbunden ist und dessen zweiter Anschluß zwischen dem die virtuelle Masse bildenden invertierenden Eingang (-) des Operationsverstärkers (V1) und dem realen Bezugspotential für den Verstärkereingang (V1) umschaltbar ist.

2. Signalverarbeitungsgerät nach Anspruch 1,
   **dadurch gekennzeichnet,**
   daß ein fester Widerstand (R11/C11) mit dem durch Parallelschaltung veränderlichen ersten Widerstand (R12/C12) zum Signaleingang (E) hin in Reihe geschaltet ist.

3. Signalverarbeitungsgerät nach einem der vorangehenden Ansprüche, **dadurch gekennzeichnet,** daß die Umschaltung mittels eines mechanischen oder elektromechanischen Schalters (S21) erfolgt.

4. Signalverarbeitungsgerät nach einem der vorangehenden Ansprüche, **dadurch gekennzeichnet,** daß die Umschaltung mittels eines integrierten Analogschalters erfolgt.

5. Signalverarbeitungsgerät nach einem der vorangehenden Ansprüche mit komplexen Widerständen, **dadurch gekennzeichnet,** daß kapazitive Anteile (C11 bis C15) der komplexen Widerstände (R12/C12, R13/C13 und C16, R14/C14 und C17, R15/C15) durch mindestens einen Trimmerkondensator (C12, C16, C17, C15) gebildet werden.

6. Signalverarbeitungsgerät nach einem der vorangehenden Ansprüche, **dadurch gekennzeichnet,** daß der eine Operationsverstärker (V1) einen hochohmigen Eichteiler bildet und daß dem einen Operationsverstärker (V1) einen weiterer Operationsverstärker (V2) mit umschaltbaren Widerständen (R22 bis R27) nachgeordnet ist.

7. Signalverarbeitungsgerät nach einem der vorangehenden Ansprüche, **dadurch gekennzeichnet,** daß die Widerstandswerte derart bemessen sind, daß sich dekadische Pegelanpassungssprünge erzeugen lassen.

8. Signalverarbeitungsgerät mit mindestens einem Verstärker, mit einer Pegelanpassungsschaltung nach einem der vorangehenden Ansprüche und einer Eingangsschaltung,

**dadurch gekennzeichnet,**

daß die Einspeisung eines Kompensationsstromes zur Gleichspannungsverschiebung und/oder zur Korrektur einzelner Amplitudenwerte innerhalb des Übertragungsfensters über den Schaltungspunkt (S) der virtuellen Masse als Summenpunkt des potentiometrisch beschalteten Verstärkers (V1) erfolgt.

9. Signalverarbeitungsgerät nach Anspruch 8, **dadurch gekennzeichnet,** daß der Summenpunkt (S) identisch ist mit dem Zusammenführungspunkt des umschaltbaren Stromteilers zur Pegelanpassung, wobei die veränderlichen Zweige des Stromteilers zwischen dem Summenpunkt (S) und dem Bezugspunkt für Verstärkerein- und -ausgang umschaltbar sind.

10. Signalverarbeitungsgerät nach einem der vorangehenden Ansprüche, **dadurch gekennzeichnet,** daß die Einspeisung durch Rückführung eines digitalen vom Ausgangssignal des Verstärkers (V2) abhängigen Signals erfolgt, das einer Digital-Analog-Wandlung unterworfen wird.

11. Signalverarbeitungsgerät nach einem der vorangehenden Ansprüche, **dadurch gekennzeichnet,** daß die Erzeugung des zurückzuführenden Signals mittels eines in einem Speicher (CAL) festgehaltenen digitalen Signals erfolgt, welches aus einem digitalen Signal gewonnen wird, das der Abweichung des analogen Ausgangsgangsignals des Verstärkers (V2) von einem vorgegebenen Analogsignal bei einem ebenfalls vorgegebenen Analogeingangssignal zugeordnet ist.

12. Signalverarbeitungsgerät nach Anspruch 11, **dadurch gekennzeichnet,** daß die Kalibrierung des Verstärkers (V2) durch Zurückführung von verschiedenen Signalen bei unterschiedlichen Eingangssignalen erfolgt, welche amplitudenmäßig über den vorgesehenen Übertragungsbereich verteilt sind.

13. Signalverarbeitungsgerät nach einem der vorangehenden Ansprüche, **dadurch gekennzeichnet,** daß ein für das zurückzuführende Signal repräsentativer Digitalwert in einem Speicher (309) festgehalten und das zurückzuführende Signal aus dem festgehaltenen Digitalwert durch Digital-Analog-Wandlung gewonnen wird.

14. Signalverarbeitungsgerät nach Anspruch 13**, dadurch gekennzeichnet,** daß in dem Speicher (309) die Digitalwerte in Abhängigkeit von verschiedenen Eingangssignalamplituden, welche den vorgesehenen Eingangssignalbereich überdecken, tabellenmäßig adressierbar festgehalten sind.

15. Signalverarbeitungsgerät nach einem der vorangehenden Ansprüche, **dadurch gekennzeichnet,** daß ein Speicher (309) mindestens mittelbar durch einen digitalisierten Meßwert adressiert wird, wobei der im adressierten Speicher (309) enthaltene Wert einen Korrektur- oder korrigierten Wert darstellt, der über einen Digital-Analog-Wandler (310) dem Summenpunkt (S) zugeführt wird.

16. Signalverarbeitungsgerät nach einem der vorangehenden Ansprüche, **dadurch gekennzeichnet,** daß die Kalibrierung unter Heranziehung eines den gewählten Meßbereich kennzeichnenden Signals erfolgt, wobei die ermittelten Digitalwerte für unterschiedliche Meßbereiche in verschiedenen Speichern festgehalten werden.

17. Signalgverarbeitungsgerät nach einem der vorangehenden Anprüche, **dadurch gekennzeichnet,** daß die Zurückführung bei einem mehrstufigen Verstärker zum Eingang einer der Verstärkerstufen - bevorzugt zu der ersten der Verstärkerstufen - erfolgt.

## Claims

1. A signal processing apparatus with a level adapter circuit, in particular a broad band oscilloscope, with an operational amplifier (VI), the gain of which is determined by the ratio of a first impedance (R12/C12) between the signal input and the inverting input of the operational amplifier - the virtual earth - to a second impedance (R15/C15) between the inverting input of the operational amplifier and signal output, wherein the impedances are possibly complex, characterised in that at least one parallel impedance (R13/C13, R14/C14) is provided for the first impedance (R12/C12), the first terminal of which parallel impedance is firmly connected to the signal input (E) or a point of connection of several partial impedances, forming the first impedance, and the second terminal of which can be switched over between the inverting input (-) of the operational amplifier (VI), which forms the virtual earth and the real reference potential for the amplifier input (VI).

2. A signal processing apparatus according to claim 1, characterised in that a fixed impedance (R11/C11) is connected in series to the first impedance (R12/C12) and towards the signal input (E),able to be varied by parallel connection.

3. A signal processing apparatus according to one of the preceding claims, characterised in that the switchover occurs by means of a mechanical or electromechanical switch (S21).

4. A signal processing apparatus according to one of the preceding claims, characterised in that the switchover occurs by means of an integrated analog switch.

5. A signal processing apparatus according to one of the preceding claims with complex impedances, characterised in that capacitive portions (C11 to C15) of the complex impedances (R12/C12, R13/C13 and C16, R14/C14 and C17, R15/C15) are formed by at least one trimming capacitor (C12, C16, C17, C15).

6. A signal processing apparatus according to one of the preceding claims, characterised in that the one operational amplifier (V1) forms a high-resistance calibration divider and in that a further operational amplifier (V2) with multi-range resistors (R22 to R27) is arranged after the operational amplifier (V1).

7. A signal processing apparatus according to one of the preceding claims, characterised in that the impedance values are proportioned such that decade steps in level adjustment are generated.

8. A signal processing apparatus with at least one amplifier, with a level adapter circuit according to one of the preceding claims and with an input circuit,
characterised in that the supply of a compensation current for a direct voltage shift and/or for correction of individual amplitude values within the transmission window occurs via the virtual earth circuit point (S) as the summation point of the amplifier (VI) connected as a potentiometer.

9. A signal processing apparatus according to claim 8, characterised in that the summation point (S) is identical to the junction point of the multi-range current divider for level adjustment, wherein the variable branches of the current divider are able to be switched over between the summation point (S) and the point of reference for the amplifier input and output.

**10.** A signal processing apparatus according to one of the preceding claims, characterised in that the supply occurs by feedback of a digital signal dependent on the output signal of the amplifier (V2), which is subjected to a digital to analog conversion.

**11.** A signal processing apparatus according to one of the preceding claims, characterised in that the generation of the signals to be returned occurs by means of a digital signal fixed in a memory (CAL), which is acquired from a digital signal, which is allocated to the variation of the analog output signal of the amplifier (V2) from a preset analog input signal with an analog input signal which is also predetermined.

**12.** A signal processing apparatus according to claim 11, characterised in that the calibration of the amplifier (V2) occurs by returning different signals in view of various input signals, which are distributed according to amplitude over the provided transmission region.

**13.** A signal processing apparatus according to one of the preceding claims, characterised in that a digital value representative for the signal to be returned is held in a memory (309) and the signal to be returned is acquired from the fixed digital value by digital to analog conversion.

**14.** A signal processing apparatus according to claim 13, characterised in that the digital values are held in the memory (309) in tables in an addressable manner and dependent upon various input signal amplitudes, which cover the provided input signal range.

**15.** A signal processing apparatus according to one of the preceding claims, characterised in that a memory (309) is addressed, at least indirectly, by a digitised measurand, wherein the value contained in the addressed memory (309) represents a correction value or corrected value, which is supplied to the summation point (S) by way of a digital to analog converter (310).

**16.** A signal processing apparatus according to one of the preceding claims, characterised in that the calibration occurs by applying a signal characterising the selected measuring region, wherein the established digital values for various measuring regions are held in various memories.

**17.** A signal processing apparatus according to one of the preceding claims, characterised in that the feedback in a multi-stage amplifier occurs to the input of one of the amplifier stages - preferably to the first of the amplifier stages.

**Revendications**

**1.** Dispositif de traitement de signaux comportant un circuit d'adaptation de niveau, notamment un oscilloscope à large bande, comprenant un amplificateur opérationnel (V1), dont le facteur d'amplification est déterminé par le rapport d'une première résistance (R12/C12) entre l'entrée des signaux et l'entrée inverseuse de l'amplificateur opérationnel -de la masse virtuelle- ainsi que d'une seconde résistance (R15/C15) entre l'entrée inverseuse de l'amplificateur opérationnel et la sortie des signaux, les résistances étant éventuellement complexes,
caractérisé par le fait que pour la première résistance (R12/C12), il est prévu au moins une résistance parallèle (R13/C13, R14/C14), dont la première borne est raccordée de façon fixe à l'entrée (E) des signaux ou à un point de jonction de plusieurs résistances partielles constituant la première résistance et dont la seconde borne peut être commutée entre l'entrée inverseuse (-), qui constitue la masse virtuelle, de l'amplificateur opérationnel (V) et le potentiel de référence réel pour l'entrée (V1) de l'amplificateur.

**2.** Dispositif de traitement de signaux suivant la revendication 1, caractérisé par le fait qu'une résistance fixe (R11/C11) est branchée en série avec la première résistance (R12/C12), modifiable au moyen du branchement en parallèle, à l'entrée (E) des signaux.

**3.** Dispositif de traitement de signaux suivant l'une des revendications précédentes, cractérisé par le fait que la commutation est réalisée au moyen d'un commutateur mécanique ou électromécanique (S21).

**4.** Dispositif de traitement de signaux suivant l'une des revendications précédentes, caractérisé par le fait que la commutation est réalisée au moyen d'un commutateur analogique intégré.

**5.** Dispositif de traitement de signaux suivant l'une des revendications précédentes comportant des résistances complexes, caractérisé par le fait que les composantes capacitives (C11 à C15) des résistances complexes (R12/C12, R13/C13 et C16, R14/C14 et C17, R15/C15) sont formées par au moins un condensateur d'ajustement (C12,C16,C17,C15).

**6.** Dispositif de traitement de signaux suivant l'une des revendications précédentes, caractérisé par le fait qu'un amplificateur opérationnel (V1) forme un diviseur d'étalonnage de forte valeur ohmique et qu'en aval d'un amplificateur opérationnel (V1) est branché un autre amplificateur opérationnel (V2) comportant des résistances commutables (R22 à R27).

**7.** Dispositif de traitement de signaux suivant l'une des revendications précédentes, caractérisé par le fait que les valeurs résistives sont dimensionnées de manière à permettre l'obtention de sauts décadiques d'adaptation de niveau.

**8.** Dispositif de traitement de signaux comportant au moins un amplificateur, un circuit d'adaptation de niveau suivant l'une des revendications précédentes, et un circuit d'entrée,
caractérisé par le fait
que l'injection d'un courant de compensation servant à décaler la tension continue et/ou corriger des valeurs individuelles d'amplitude à l'intérieur de la fenêtre de transmission s'effectue par l'intermédiaire de points de circuit (S) de la masse virtuelle en tant que point de sommation de l'amplificateur (V1) à branchement potentiométrique.

**9.** Dispositif de traitement de signaux suivant la revendication 8, caractérisé par le fait que le point de sommation (S) est identique au point de réunion du diviseur de courant commutable avec le circuit d'adaptation de niveau, les branches variables du diviseur de courant pouvant être commutées entre le point de sommation (S) et le point de référence pour l'entrée et la sortie de l'amplificateur.

**10.** Dispositif de traitement de signaux suivant l'une des revendications précédentes, caractérisé par le fait que l'injection s'effectue par renvoi d'un signal numérique qui dépend du signal de sortie de l'amplificateur (V2) et est soumis à une conversion numérique/analogique.

**11.** Dispositif de traitement de signaux suivant l'une des revendications précédentes, caractérisé par le fait que la production du signal devant être renvoyé s'effectue au moyen d'un signal numérique, qui est conservé dans une mémoire (CAL) et est obtenu par un signal numérique, qui est associé à l'écart entre le signal de sortie analogique de l'amplificateur (V2) et un signal analogique prédéterminé, pour un signal d'entrée analogique également prédéterminé.

**12.** Dispositif de traitement de signaux suivant la revendication 11, caractérisé par le fait que le calibrage de l'amplificateur (V2) est réalisé par renvoi de différents signaux, dans le cas de signaux d'entrée différents, qui sont répartis, du point de vue de leurs amplitudes, dans la gamme prévue de transmission.

**13.** Dispositif de traitement de signaux suivant l'une des revendications précédentes, caractérisé par le fait qu'une valeur numérique représentative du signal devant être renvoyé est conservée dans une mémoire (309) et que le signal devant être renvoyé est obtenu à partir de la valeur numérique conservée, par conversion numérique/analogique.

**14.** Dispositif de traitement de signaux suivant la revendication 13, caractérisé par le fait que les valeurs numériques sont conservées de manière à pouvoir être adressées sous la forme d'un tableau dans la mémoire (309), en fonction de différentes amplitudes du signal d'entrée, qui couvrent la gamme prévue de signaux d'entrée.

**15.** Dispositif de traitement de signaux suivant l'une des revendications précédentes, caractérisé par le fait qu'une mémoire (309) est adressée au moins indirectement par une valeur de mesure numérisée, la valeur contenue dans la mémoire adressée (309) représentant une valeur de correction ou une valeur corrigée, qui est envoyée au point de sommation (S) par un convertisseur numérique/analogique (310).

**16.** Dispositif de traitement de signaux suivant l'une des revendications précédentes, caractérisé par le fait que le calibrage s'effectue en utilisant un signal caractérisant la plage de mesure sélectionnée, la valeur numérique déterminée étant conservée pour différentes plages de mesure dans des mémoires différentes.

**17.** Dispositif de traitement de signaux suivant l'une des revendications précédentes, caractérisé par le fait que le renvoi s'effectue, dans le cas d'un amplificateur à étages multiples, à l'entrée de l'un des étages de l'amplificateur -de préférence du premier des étages amplificateurs.

Fig. 1a

Fig. 1b

Fig. 1c

Fig.2

Fig. 3

EP 0 252 085 B1